Europäisches Patentamt

European Patent Office

Office européen des brevets

(11) Numéro de publication: **0 153 208**
**A1**

## (12) DEMANDE DE BREVET EUROPEEN

(21) Numéro de dépôt: 85400115.3

(22) Date de dépôt: 24.01.85

(51) Int. Cl.⁴: **H 03 K 17/10**

---

(30) Priorité: 25.01.84 FR 8401152

(43) Date de publication de la demande: 28.08.85
**Bulletin 85/35**

(84) Etats contractants désignés: **DE FR GB IT**

(71) Demandeur: **JEUMONT-SCHNEIDER Société anonyme dite:, 31-32, Quai de Dion Bouton, F-92811 Puteaux Cedex (FR)**

(72) Inventeur: **Petit, Jean Paul, 12, Allée des Eiders, F-75019 Paris (FR)**

(74) Mandataire: **Lejet, Christian, Société JEUMONT-SCHNEIDER 31-32, Quai de Dion Bouton, F-92811 Puteaux Cedex (FR)**

---

(54) **Montage en série de transistors de puissance.**

(57) Selon l'invention, un circuit d'équilibrage (2) comportant deux enroulements (L1) et (L2) détecte un courant (Ids) entre la jonction commune émetteur-collecteur de deux transistors en série et la jonction commune des capacités d'équilibrage pour rééquilibrer les tensions (VCE) des transistors.

La présente invention trouve application dans le domaine de l'électronique de puissance et de l'électrotechnique où des tensions élevées et de fort courant sont exigées.

## MONTAGE EN SERIE DE TRANSISTORS DE PUISSANCE

La présente invention concerne le montage en série d'au moins deux transistors de puissance.

Les progrès accomplis dans la technologie du transistor de puissance en font un élément commutateur utilisable dans les domaines de l'électronique de puissance et de l'électrotechnique exigeant des tensions et courants importants.

Ainsi, on trouve aujourd'hui des transistors de puissance à fort courant (de plusieurs dizaines d'ampères) et gain faible et à forte tension VCEO (tenue en tension collecteur-émetteur du transistor à circuit de base ouvert, soit à courant de base Ib=0) de l'ordre de 800 Volts, et ayant ainsi des charges stockées importantes.

Seulement, les besoins notamment de l'électrotechnique s'étendent souvent à des tensions plus élevées,d'où l'intérêt de réaliser la mise en série de transistors de puissance.

Cependant, le montage en série d'au moins deux transistors de puissance exige dans tous les cas de fonctionnement un équilibrage aussi parfait que possible en tensions VCE (tension collecteur-émetteur des transistors).

En régime statique de fonctionnement d'au moins deux transistors en série, le problème d'équilibrage est facilement résolu en utilisant deux résistances en série commutées en parallèle entre le collecteur de l'un des transistors et l'émetteur de l'autre transistor de manière à former un pont de résistances d'équilibrage.

En régime de fonctionnement dynamique et notamment à l'allumage des transistors en série, les dispersions en temps ou temps pendant lequel s'effectue la montée du courant collecteur, tandis que la tension VCE reste égale à la tension d'alimentation, sont de l'ordre de la microseconde. L'équilibrage peut alors être résolu avec des condensateurs de quelques microfarads.

Aux commutations de blocage, les transistors hautes tensions, fort courant, donc faible gain, ont des charges stockées dans la jonction base-collecteur très importantes et souvent très variables d'un transistor à l'autre. Les temps de reblocage qui s'étendent sur plusieurs dizaines de microsecondes nécessitent l'utilisation de condensateurs d'équilibrage de capacité élevée.

Seulement, les coûts et volumes des condensateurs de capacité élevée grèvent fortement l'intérêt de la mise en série de transistors de puissance.

La présente invention a pour but de remédier à l'inconvénient ci-dessus en proposant un circuit d'équilibrage des transistors simple et efficace.

Pour cela, l'invention se rapporte au montage en série d'au moins deux transistors de puissance, chacun commandé à sa base par un dispositif de commande et comprenant un condensateur d'équilibrage dynamique, les condensateurs étant montés en série avec leur jonction commune reliée à la jonction collecteur-émetteur des deux transistors en série par une liaison traversée par un courant lors du changement d'état des deux transistors en série, caractérisé en ce que la liaison est réalisée sous forme d'un circuit d'équilibrage comportant des moyens sensibles au courant et des moyens générateurs de signaux d'équilibrage agissant sur les dispositifs de commande pour augmenter le courant de base de l'un des transistors et réduire le courant de base de l'autre transistor selon la grandeur et le sens du courant, afin d'annuler ce courant circulant à travers la liaison.

Selon une autre caractéristique de l'invention, les moyens sensibles et les moyens générateurs du circuit d'équilibrage sont constitués par deux enroulements en série, chacun inductivement lié au dispositif de commande.

Selon encore une autre caractéristique avantageuse de l'invention, chaque enroulement du circuit d'équilibrage est inductivement lié à un enroulement secondaire d'un transformateur de commande isolant galvaniquement chaque transistor de puissance d'un générateur commun de signaux de commande.

L'invention sera mieux comprise, et d'autres buts, caractéristiques, détails et avantages de celle-ci apparaîtront plus clairement au cours de la description explicative qui va suivre faite en référence aux dessins schématiques annexés donnés uniquement à titre d'exemple illustrant un mode de réalisation de l'invention et dans lesquels :

- la figure 1 représente un montage en série de deux transistors de puissance auquel s'applique la présente invention ;

- la figure 2 représente le montage en série de deux transistors de puissance comportant le circuit d'équilibrage selon l'invention ; et

- les figures 3a, 3b et 3c montrent les différentes courbes des tensions et courants obtenus par l'équilibrage des transistors lors de leur commutation de blocage.

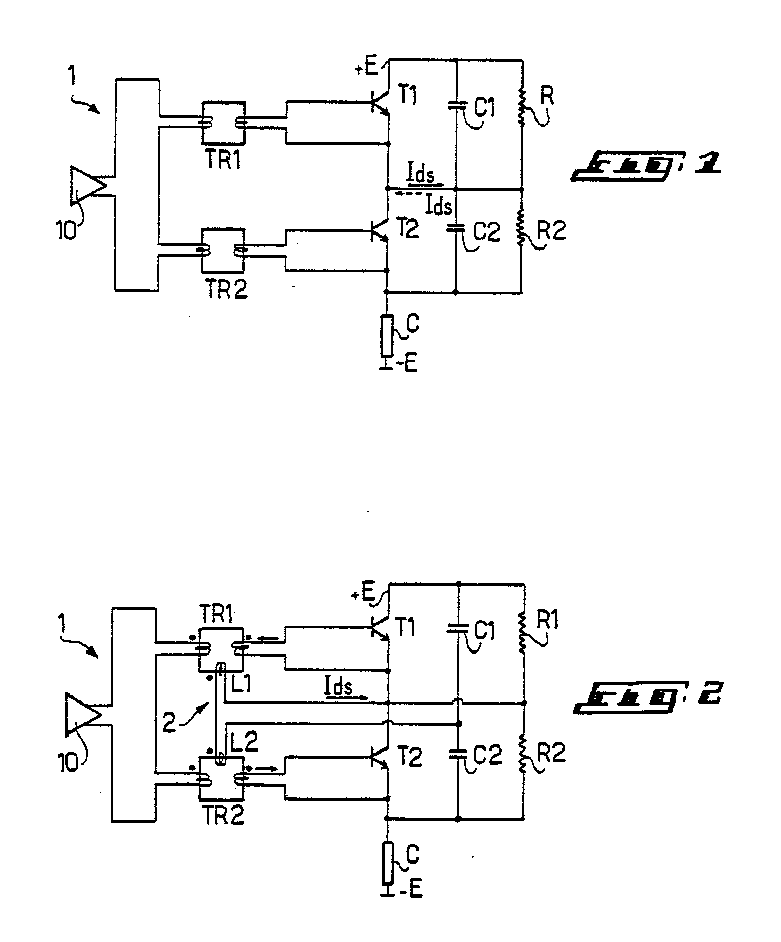

En se rapportant à la figure 1, il est représenté un montage en série de deux transistors de puissance T1 et T2, l'émetteur du transistor T1 étant relié au collecteur du transistor T2.

Une charge C, par exemple une charge inductive est reliée d'une part par de l'une de ses bornes à la tension négative -E de la tension d'alimentation de puissance et d'autre part par son autre borne à l'émetteur du transistor de puissance T2, le collecteur du transistor de puissance T1 étant relié à la tension positive +E de la tension d'alimentation. Bien entendu, la charge C, au lieu d'être reliée au circuit émetteur du transistor T2, peut être reliée au circuit collecteur du transistor T1. Chaque transistor de puissance T1 et T2 est commandé à sa base par un circuit de commande 1 comportant un générateur 10 de signaux appropriés de commande et deux transformateurs de commande TR1 et TR2 isolant galvaniquement respectivement les transistors de puissance T1 et T2 du générateur 10 de signaux de commande. Ainsi, comme il ressort de la figure 1, les enroulements primaires des transformateurs de commande TR1 et TR2 sont reliés en série, leurs bornes extrêmes étant reliées en sortie du générateur 10. L'enroulement secondaire du transformateur de commande TR1 est relié entre la base et l'émetteur du transistor de puissance T1, tandis que l'enroulement secondaire du transformateur de commande TR2 est relié entre la base et l'émetteur du transistor de puissance T2. L'isolement galvanique entre un circuit générateur de signaux de commande et l'étage de puissance constitué par deux transistors de puissance est déjà connu en soi, il n'a donc pas à faire l'objet d'une description plus détaillée.

Deux résistances en série R1 et R2 sont montées entre le collecteur du transistor T1 et l'émetteur du transistor T2 et ont leur jonction commune reliée à la jonction commune émetteur-collecteur des transistors T1 et T2. Ces deux résistances forment en quelque sorte un pont d'équilibrage des tensions VCE en régime statique de fonctionnement des transistors T1 et T2 comme cela est déjà connu en soi.

Deux condensateurs C1 et C2 reliés en série entre le collecteur du transistor T1 et l'émetteur du transistor T2 ont également leur jonction commune reliée à la jonction commune des transistors T1 et T2, ces deux condensateurs servant à l'équilibrage en tension en régime dynamique de fonctionnement de ces transistors.

Avec chacun des transistors de puissance T1 et T2 ayant un VCEO (tenue en tension, base ouverte) actuellement de l'ordre de 800 Volts, on comprend que les transistors T1 et T2 mis en série peuvent supporter une tension d'alimentation élevée lors de leur blocage, la charge C ayant une tension élevée à ses bornes et étant parcourue par un courant important lors de la conduction de ces transistors, et ce tout en ayant un équilibre tant en régime statique que dynamique satisfaisant.

Cependant, afin d'éviter l'utilisation de condensateurs de forte capacité durant les commutations de blocage des transistors T1 et T2, l'invention prévoit des moyens d'équilibrage simples et efficaces.

En effet, lors d'un déséquilibrage en tensions VCE, lors du changement d'état des transistors T1 et T2, un courant appelé Ids circule à travers la liaison entre la jonction commune émetteur-collecteur des deux transistors et la jonction commune des condensateurs C1 et C2. Le sens et l'amplitude de ce courant Ids dépendent des valeurs relatives des tensions $VCE_1$ et $VCE_2$ des transistors T1 et T2. Ainsi, le courant Ids a le sens indiqué par la flèche en trait fort comme montré sur la figure 1 lorsque $VCE_2$ varie plus fortement que $VCE_1$ dans le temps, c'est-à-dire, lorsque la dérivée de $VCE_2$ par rapport au temps est supérieure à la dérivée de $VCE_1$ par rapport au temps (soit :

$$\frac{dVCE_2}{dt} > \frac{dVCE_1}{dt} \quad )$$

Le sens de Ids sera celui indiqué en traits pointillés sur la figure 1 quand :

$$\frac{dVCE_2}{dt} < \frac{dVCE_1}{dt}$$

Le circuit selon la présente invention a pour but de mesurer le sens et l'amplitude du courant Ids et d'agir sur les courants de base des transistors, afin de rééquilibrer les tensions VCE des transistors en bénéficiant de leur gain ($\beta$).

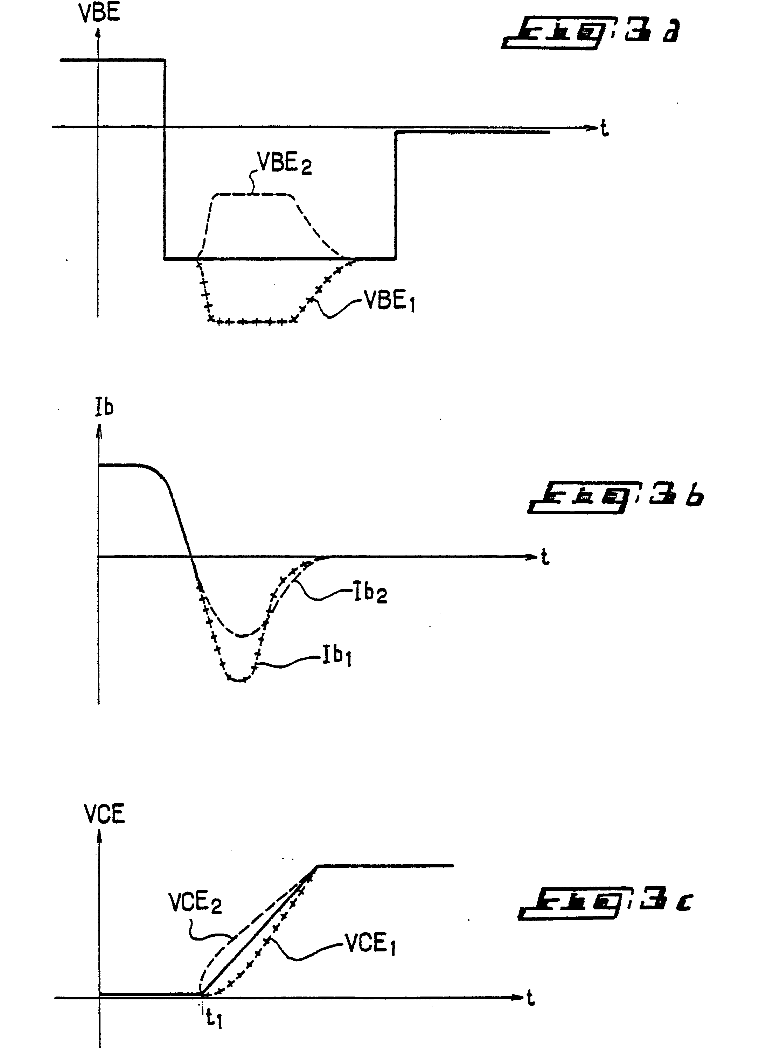

Un tel circuit est représenté dans le montage de la figure 2, les éléments communs avec celui de la figure 1 portant les mêmes références.

Comme représenté sur cette figure 2, le circuit d'équilibrage 2 des transistors de puissance T1 et T2 comprend deux enroulements L1 et L2 montés en série, les bornes extrêmes de ces enroulements étant connectées entre la jonction commune des transistors T1 et T2 et la jonction commune des condensateurs C1 et C2.

L'enroulement L1 forme en fait un enroulement supplémentaire du transformateur de commande TR1 inductivement lié à l'enroulement secondaire de ce transformateur, tandis que l'enroulement L2 est un enroulement supplémentaire du transformateur de commande TR2 inductivement lié à l'enroulement secondaire de celui-ci. Ainsi, ce circuit d'équilibrage est capable de détecter un courant Ids circulant à travers les enroulements L1 et L2 et de générer des signaux d'équilibrage dans les enroulements secondaires des transformateurs de commande agissant sur les courants de base des transistors T1 et T2, afin d'équilibrer les tensions VCE, l'équilibre étant atteint lorsque Ids=0.

A titre d'exemple, le fonctionnement du circuit d'équilibrage des transistors va être décrit au cours des commutations de blocage de ces transistors en se référant aux figures 3a à 3c.

La figure 3b montre le courant de base Ib en fonction du temps appliqué à l'entrée des transistors de puissance T1 et T2. Au cours de la commutation de blocage des transistors, le courant Ib diminue de sa valeur correspondant à la conduction des transistors pour atteindre une valeur négative nécessaire à la diminution du temps de blocage des transistors, la tension VBE des transistors devenant alors négative comme représenté en traits forts en figure 3a.

Quelques instants après que Ib=0 (c'est-à-dire, quand les transistors T1 et T2 ne sont plus conducteurs), les tensions VCE commencent à augmenter jusqu'à atteindre la tension de blocage des transistors comme représenté en figure 3c.

Cependant, à cet instant t1 où les tensions VCE commencent à augmenter un déséquilibre de ces tensions peut être créé dans le cas où par exemple :

$$\frac{dVCE_2}{dt} > \frac{dVCE_1}{dt}$$

ce qui se traduit par un courant de déséquilibre Ids ayant le sens indiqué en figure 2. Le courant circulant à travers les enroulements L1 et L2 induit dans les enroulements des transformateurs TR1 et TR2 des courants dont les sens sont indiqués par les flèches en trait fort et dont l'amplitude est tributaire de celle du courant Ids. Le courant circulant à travers l'enroulement secondaire du transformateur TR1 va rendre plus négatif donc augmenter le courant Ib1, tandis que le courant circulant à travers l'enroulement secondaire du transformateur TR2 va rendre moins négatif donc diminuer le courant Ib2 de T2, comme montré en figure 3b.

Le passage de ces courants d'équilibrage à travers les enroulements secondaires des transformateurs va donc modifier les tensions VBE1 et VBE2, comme montré en figure 3a. Cette action sur les tensions VBE1 et VBE2 des transistors T1 et T2 permet de rétablir l'équilibre des tensions VCE de ces transistors, ces tensions VCE variant de la même quantité par rapport au temps tout en préservant l'équilibre des transistors. Le courant Ids sera alors nul à l'équilibre. Tout déséquilibrage est donc détecté par le circuit d'équilibrage pendant la commutation de blocage des transistors jusqu'à ce que les tensions VCE atteignent la tension de blocage.

La description ci-dessus concernant la façon dont le courant Ids agit sur les tensions a été faite en référence aux commutations de blocage des transistors, mais il est bien évident que le courant agit sur le circuit d'équilibrage également lors des commutations de saturation des transistors.

Bien entendu, l'utilisation du circuit d'équilibrage selon l'invention peut s'étendre à plusieurs transistors, l'équilibrage de ces transistors s'effectuant toujours deux à deux.

Enfin, d'autres moyens pour le circuit d'équilibrage peuvent être utilisés sans sortir du cadre de la présente invention pourvu que ce circuit d'équilibrage comporte des moyens détectant un courant entre la jonction commune émetteur-collecteur des transistors de puissance et la jonction commune des condensateurs et des moyens générateurs de signaux d'équilibrage répondant au courant apparaissant, afin de rétablir l'équilibre des transistors.

On a donc réalisé par la présente invention, un circuit d'équilibrage simple, efficace, facile à mettre en oeuvre et de faible coût.

REVENDICATIONS

1. Montage en série d'au moins deux transistors de puissance, chacun commandé à sa base par un dispositif de commande et comprenant un condensateur d'équilibrage dynamique, les condensateurs étant montés en série avec leur jonction commune reliée à la jonction collecteur-émetteur des deux transistors en série par une liaison traversée par un courant lors du changement d'état des deux transistors en série, caractérisé en ce que ladite liaison est réalisée sous forme d'un circuit d'équilibrage (2), comportant des moyens (L1, L2) sensibles au courant et des moyens (L1, L2) générateurs de signaux d'équilibrage agissant sur les dispositifs de commande (10, TR1, 10, TR2) pour augmenter le courant de base de l'un des transistors (T1, T2) et réduire le courant de base de l'autre transistor (T2, T1) selon la grandeur et le sens du courant (Ids), afin d'annuler ce courant à travers ladite liaison.

2. Montage selon la revendication 1, caractérisé en ce que les moyens sensibles précités et les moyens générateurs précités du circuit d'équilibrage (2) sont constitués par deux enroulements (L1) et (L2) en série, l'enroulement (L1) étant inductivement lié au dispositif de commande (10, TR1), tandis que l'enroulement (L2) est inductivement lié au dispositif de commande (10, TR2).

3. Montage selon la revendication 1 ou 2, caractérisé en ce que l'enroulement (L1) précité du circuit d'équilibrage (2) est inductivement lié à un enroulement secondaire d'un transformateur de commande (TR1) du dispositif de commande, tandis que l'enroulement (L2) précité est inductivement lié à un enroulement secondaire d'un transformateur (TR2) du dispositif de commande, les transformateurs de commande (TR1) et (TR2) isolant galvaniquement chaque transistor de puissance (T1) et (T2) d'un générateur commun (10) de signaux de commande.

Fig. 1

Fig. 2

VBE

Fig. 3a

$VBE_2$

$VBE_1$

Ib

Fig. 3b

$Ib_2$

$Ib_1$

VCE

$VCE_2$

Fig. 3c

$VCE_1$

$t_1$

Office européen
des brevets

**RAPPORT DE RECHERCHE EUROPEENNE**

0153208
Numéro de la demande

EP 85 40 0115

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | ELECTRONIQUE INDUSTRIELLE, no. 25, 1 décembre 1981, pages 31-35, Paris, FR; P. ITICSOHN: "Des transistors en série, une méthode originale pour la commutation haute tension" * Page 33, colonne du milieu, dernier alinéa - page 34, colonne de gauche, premier alinéa; figures 2,4 * | 1 | H 03 K 17/10 |
| A | GB-A-1 236 212 (WESTINGHOUSE) * Page 1, ligne 77 - page 2, ligne 86; figure 1 * | 1 | |
| A | GB-A- 917 382 (GENERAL ELECTRIC) * Page 2, ligne 52 - page 3, ligne 55; figure * | 1 | |

DOMAINES TECHNIQUES RECHERCHES (Int. Cl.4)

H 03 K
H 02 M

Le présent rapport de recherche a été établi pour toutes les revendications

| Lieu de la recherche | Date d'achèvement de la recherche | Examinateur |
|---|---|---|
| LA HAYE | 29-04-1985 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82